**Europäisches Patentamt**

**European Patent Office**

**Office européen des brevets**

(19)

(11) **EP 1 496 344 A2**

(12) **EUROPÄISCHE PATENTANMELDUNG**

(43) Veröffentlichungstag:
 **12.01.2005 Patentblatt 2005/02**

(51) Int Cl.⁷: **G01L 1/18**, G01L 1/22,
 G01L 5/00

(21) Anmeldenummer: **04016133.3**

(22) Anmeldetag: **08.07.2004**

(84) Benannte Vertragsstaaten:
 **AT BE BG CH CY CZ DE DK EE ES FI FR GB GR
 HU IE IT LI LU MC NL PL PT RO SE SI SK TR**
 Benannte Erstreckungsstaaten:
 **AL HR LT LV MK**

(30) Priorität: **09.07.2003 DE 10331096**

(71) Anmelder: **Austriamicrosystems AG
 8141 Unterpremstätten (AT)**

(72) Erfinder:
 • **Kempe, Volker
  8501 Lieboch (AT)**
 • **Huszka, Zoltan
  1037 Budapest (HU)**

(74) Vertreter: **Epping Hermann & Fischer
 Ridlerstrasse 55
 80339 München (DE)**

(54) **Integrierte Halbleiteranordnung und Verfahren zur Erzeugung eines druckabhängigen Signals sowie Verfahren zur Erzeugung eines temperaturabhängigen Signals**

(57) Die vorliegende Erfindung betrifft eine integrierte Halbleiteranordnung, bei der zwei Bauteile von einem ersten Leitfähigkeitstyp (1, 2) rechtwinkelig zueinander angeordnet und seriell verschaltet sind und zwei Bauteile von einem entgegengesetzten, zweiten Leitfähigkeitstyp (3, 4) ebenfalls rechtwinkelig angeordnet und seriell miteinander verschaltet sind. Eine Auswerteschaltung (5) ist mit den beiden Serienschaltungen gekoppelt. Mit der beschriebenen Anordnung ist es möglich, wie vorliegend mathematisch hergeleitet wird, ein temperaturproportionales Signal zu erzeugen, welches unabhängig ist von mechanischen Spannungen in der bzw. Druckeinwirkung auf die Halbleiteranordnung, ebenso wie ein druckproportionales, temperaturunabhängiges Signal. Das beschriebene Prinzip ist bevorzugt bei Hall-Magnet-Sensoren zur Kompensation von mechanischen Spannungen sowie Temperatureffekten anwendbar.

FIG 1

EP 1 496 344 A2

## Beschreibung

Die vorliegende Erfindung betrifft eine integrierte Halbleiteranordnung sowie ein Verfahren zur Erzeugung eines druckabhängigen Signals und ein Verfahren zur Erzeugung eines temperaturabhängigen Signals sowie die Anwendung des Verfahrens in einem Hall-Magnetsensor.

Es ist in der Fachwelt allgemein bekannt, daß sich ein Zustand von mechanischer Spannung einstellt während oder nach der Einkapselung von Halbleiterchips. Der Vorgang der Einkapselung wird auch als Packaging bezeichnet. Die einzelnen Komponenten der mechanischen Spannungen führen dazu, daß in elektrischen Schaltkreisen, die sich im eingekapselten Halbleiterchip befinden, elektronische Parameter ändern. Dies wiederum führt dazu, daß sich die elektrischen Eigenschaften des Bauteils in unbeabsichtigter Weise verändern. Natürlich betrifft dieser unerwünschte Einfluß auch diejenigen Teile des Schaltkreises, die gewöhnlich zur Erzeugung temperaturproportionaler Signale verwendet werden. Hierdurch wird die beabsichtigte Abhängigkeit des temperaturabhängigen Signals gestört. Es werden derzeit beträchtliche Anstrengungen unternommen, um diese Effekte zu analysieren, zu reduzieren und zu kompensieren.

Bevor ein korrigierender Eingriff möglich ist, ist es selbstverständlich zunächst erforderlich, die Komponenten der relevanten mechanischen Spannungen exakt zu bestimmen. Sowohl im Wafer als auch im elektronischen Package herrscht hauptsächlich ein planarer Spannungszustand vor. Dieser kann durch drei Spannungskomponenten charakterisiert werden, nämlich eine Scherspannung und zusätzlich zwei weitere Spannungskomponenten, welche in der Hauptebene des Chips liegen und senkrecht aufeinander stehen. Anstelle der beiden Spannungskomponenten in der Ebene kann auch eine andere Schreibweise verwendet werden, die sich zusammensetzt aus einem biaxialen hydrostatischen, also richtungsunabhängigen, Anteil und einem Spannungsdifferenzanteil gemäß den Formeln

$$\sigma_{PH} = \frac{\sigma_{11} + \sigma_{22}}{2}; \qquad \sigma_{PD} = \frac{\sigma_{11} - \sigma_{22}}{2}.$$

Offensichtlich sind beide Darstellungen äquivalent. Da letztere zu einfacheren Formeln führt, wird diese in vorliegendem Dokument ohne Beschränkung der Allgemeinheit verwendet.

Besonders problematisch ist es, die Auswirkungen von Temperaturänderungen von den Auswirkungen der mechanischen Spannungen im Halbleiterchip zu trennen. Temperatureffekte können beträchtliche Fehler in der Bestimmung der einzelnen Spannungskomponenten verursachen.

Dies wird beispielsweise in dem Dokument R. C. Jaeger, R. Ramani, J. Suhling: "Thermally induced Errors in the Calibration and Application of Silicon Piezoresistive Stress Sensors" EEP-Vol. 4-1, Advances in Electronic Packaging, pp. 457-470, ASME Sept. 1993. Die Autoren zeigen darin, daß es insbesondere nicht möglich ist, die Spannungskomponenten in der Ebene in temperaturkompensierter Weise aufzulösen.

Die einzige bekannte Methode zur temperaturkompensierten Bestimmung der mechanischen Spannungskomponenten in der Ebene ist die Messung der Variation der Hall-Empfindlichkeit. Dies ist beschrieben von D. Manic, R. S. Popovic und J. Petr in "Measurements of Mechanical Stress Drift in IC Plastic Packages using the Piezo-Hall Effect. Dieses Verfahren macht sich die Tatsache zunutze, daß eine Empfindlichkeitsänderung des Hall-Effekts, welche durch mechanische Spannung verursacht wird, eine geringe Temperaturempfindlichkeit hat und hauptsächlich von den Streßkomponenten in der Ebene bestimmt wird.

Dieses Verfahren erfordert jedoch in nachteilhafter Weise eine hochempfindliche Schaltungstechnik. Die Realisierung derselben auf dem Chip erzeugt eine beträchtliche Abwärme. Darüber hinaus kann das beschriebene Verfahren natürlich nicht dazu angewendet werden, den Temperaturdrift der Hall-Empfindlichkeit selbst zu kompensieren.

In Abhängigkeit der Einwirkung mechanischer Spannungen und der Temperatur ändert sich der Widerstandswert eines Widerstands, der in einem kristallinem Halbleiter integriert ist.

In dem Aufsatz von D. A. Bittle: "Piezoresistive Stress Sensors for Structural Analysis of Electronic Packages", Auburn University, Auburn, Alabama, Journal of Electronic Packaging, September 1991, Vol. 113, pp. 203 - 215 werden die grundlegenden Theorien der Druck-induzierten Widerstandsänderung im Halbleiter behandelt.

In der Druckschrift R. C. Jäger, J. C. Suhling, R. Ramani, A. T. Bradley und J. Xu: "CMOS Stress Sensors on (100) silicon", IEEE Journal of Solid-State Circuits, Vol. 35, No.1, January 2000, sind unter anderem die relevanten Formeln beschrieben, die es erlauben, einige der mechanischen Spannungskomponenten in temperaturkompensierter Weise von relativen Widerstandsänderungen herzuleiten, wenn die piezoresistiven Koeffizienten des Materials bekannt sind.

Die Grenzen dieses Vorgehens sind jedoch beispielsweise in dem Dokument R. A. Cordes at al.: "Optimal Temperature compensated Piezoresistive Stress Sensor Rosettes", EEP-Vol.13/AMD-Vol.214, Application of Experimental Mechanics to Electronic Packaging, ASME 1995, pp. 109 - 116 aufgezeigt, gemäß dem die Bestimmung der senkrecht zueinander stehenden mechanischen Spannungskomponenten in der Ebene nicht in temperaturkompensierter Weise möglich ist.

Aufgabe der vorliegenden Erfindung ist es, eine integrierte Halbleiteranordnung anzugeben, welche es ermöglicht, ein temperaturunabhängiges Signal zu erzeugen, welches proportional ist zu allen Komponenten der mechanischen Spannung in einer Ebene sowie zur Erzeugung eines temperaturproportionalen Signals, welches unabhängig von mechanischen Spannungen im Halbleiter ist. Weiterhin ist es eine Aufgabe der Erfindung, ein Verfahren zur Erzeugung eines druckunabhängigen, temperaturproportionalen Signals sowie ein Verfahren zur Erzeugung eines temperaturabhängigen, von den mechanischen Spannungen in der Ebene unabhängigen Signals anzugeben.

Bezüglich der Hälbleiteranordnung wird die Aufgabe gelöst durch eine integrierte Halbleiteranordnung, umfassend

- ein erstes Bauteil von einem ersten Leitfähigkeitstyp mit druckabhängiger elektrischer Eigenschaft,
- ein zweites Bauteil vom ersten Leitfähigkeitstyp mit druckabhängiger elektrischer Eigenschaft, das im rechten Winkel zum ersten Bauteil vom ersten Leitfähigkeitstyp angeordnet und mit diesem in einer Serienschaltung verschaltet ist,
- ein erstes Bauteil von einem zweiten Leitfähigkeitstyp mit druckabhängiger elektrischer Eigenschaft,
- ein zweites Bauteil vom zweiten Leitfähigkeitstyp mit druckabhängiger elektrischer Eigenschaft, das im rechten Winkel zum ersten Bauteil vom zweiten Leitfähigkeitstyp angeordnet und mit diesem in einer Serienschaltung verschaltet ist, und
- eine Auswerteschaltung, die mit den Serienschaltungen der Bauteile vom ersten und vom zweiten Leitfähigkeitstyp gekoppelt und so ausgelegt ist, daß an einem Ausgang der Auswerteschaltung ein temperaturunabhängiges Drucksignal und/oder ein druckunabhängiges Temperatursignal abgegeben wird.

Wie nachfolgend mathematisch hergeleitet wird, ermöglicht es die vorgeschlagene Halbleiteranordnung aufgrund der vorgesehenen Anordnung von Bauteilen mit bestimmten Leitfähigkeitstypen zueinander, die Effekte von Temperatur einerseits und mechanischen Spannungen in der Hauptebene des Halbleiters andererseits voneinander zu trennen, derart, daß ein druckunabhängiges Temperatursignal und/oder ein temperaturunabhängiges Drucksignal abgegeben werden kann. Hierzu sind zwei Serienschaltungen vorgesehen, die mit einer Auswerteschaltung gekoppelt sind und je zwei Bauteile umfassen. Erstes und zweites Bauteil der ersten Serienschaltung sind von einem ersten Leitfähigskeitstyp und in einem Winkel von 90 Grad zueinander angeordnet. Erstes und zweites Bauteil der zweiten Serienschaltung sind von einem zweiten Leitfähigkeitstyp, der dem ersten Leitfähigkeitstyp entgegengesetzt ist und sind ebenfalls in einem Winkel von 90 Grad zueinander angeordnet.

Es entspricht dabei dem vorliegenden Prinzip, dass Signaländerungen über den beiden Serienschaltungen, die durch Druckund/oder Temperaturänderungen hervorgerufen werden können, miteinander verknüpft werden, derart, dass temperaturabhängige oder druckabhängige Eigenschaften herausfallen.

Zur Erzeugung eines temperaturkompensierten Signals ist bevorzugt vorgesehen, vor der Verknüpfung der Signaländerungen eine der beiden Signaländerungen mit dem Verhältnis der Temperaturkoeffizienten der Bauteile von unterschiedlichem Leitfähigkeitstyp zu gewichten.

Zur Erzeugung eines Druck-kompensierten Signals ist bevorzugt vorgesehen, vor der Verknüpfung der Signaländerungen miteinander eine der beiden Signaländerungen mit dem absoluten Verhältnis der Summen der druckabhängigen piezoresitiven Koeffizienten in der Hauptebene der integrierten Halbleiteranordnung der Bauteile vom ersten und zweiten Leitfähigkeitstyp zu gewichten.

Unter der Anordnung von 90 Grad der Bauteile zueinander ist bevorzugt verstanden, daß diese bei Beaufschlagung mit einem jweiligen elektrischen Signal von Strömen durchflossen werden, die im Wesentlichen in einem rechten Winkel zueinander stehen.

Unter dem Winkel von 90 Grad der Bauteile zueinander ist bevorzugt verstanden, daß diese über je zwei Anschlußklemmen verfügen, welche je eine Achse definieren, wobei die Achsen der Bauteile orthogonal zueinander stehen.

Allgemein gilt, daß die Bauteile vom ersten und zweiten Leitfähigkeitstyp bevorzugt Widerstände sind.

Weiterhin sind die Bauteile vom ersten und zweiten Leitfähigkeitstyp bevorzugt Piezowiderstände. Es können jedoch auch alle anderen elektronischen, bevorzugt passiven Bauteile verwendet werden, welche geeignet sind, ein druck- und temperaturabhängiges Signal abzugeben und welche in integrierter Schaltungstechnik in Gebieten von verschiedenem Leitfähigkeitstyp integrierbar sind.

Die Piezowiderstände sind bevorzugt monolithisch integriert.

Mathematisch kann das vorliegende Prinzip anhand von Piezo-Widerständen wie folgt hergeleitet werden:

Die relative Widerstandsänderung ist allgemein eine periodische Funktion des Winkels gemessen von einer beliebigen Achse in einer beliebig orientierten Siliziumoberfläche:

$$\frac{\Delta R}{R} = \delta = \xi\cos(2\Psi) + \eta\sin(2\Psi) + \zeta$$

Die drei Koeffizienten $\xi$, $\eta$ und $\zeta$ sind Funktionen der Temperatur, der mechanischen Druckbeanspruchung, im folgenden auch als Streß bezeichnet, und die Elemente des Sensors des Piezowiderstands für die gegebene Orientierung der Siliziumoberfläche. Für Siliziumwafer, die gemäß Industriestandard eine (100) Orientierung haben, wird der Winkel $\psi$ gemessen von der Achse [-1 1 0] parallel zur Ebene. Die drei Koeffizienten sind in diesem Fall

$$\xi = \pi_{44}\sigma_{PD}$$

$$\eta = \pi_D\sigma_{12}$$

$$\zeta = \pi_S\sigma_{PH} + \pi_{12}\sigma_{33} + \alpha\Delta T .$$

Darin sind

$\sigma_{PH} = \dfrac{\sigma_{11} + \sigma_{22}}{2}$      der biaxiale, hydrostatische Streß,

$\sigma_{PD} = \dfrac{\sigma_{11} - \sigma_{22}}{2}$      die orthogonale Streß-Differenz in der Hauptebene,

$\pi_S = \pi_{11} + \pi_{12}; \pi_D = \pi_{11} - \pi_{12}$      die kombinierten piezoresistiven Koeffizienten,

$\alpha$      der Temperaturkoeffizient des Widerstands und

$\Delta T$      die Temperaturdifferenz zwischen mechanisch unbeanspruchten und beanspruchten Zuständen des Piezowiderstandes.

Wenn man die Notationen

$$d_{\Psi 1/\Psi 2} = \frac{\delta_{\Psi 1} - \delta_{\Psi 2}}{2}; \qquad s_{\Psi 1/\Psi 2} = \frac{\delta_{\Psi 1} + \delta_{\Psi 2}}{2}$$

für die Differenz beziehungsweise die Summe der relativen Widerstandsänderungen einführt für zwei Widerstände, die mit Winkel $\psi 1$ und $\psi 2$ zur $x_1$-Achse liegen, so können diese Streß-Komponenten ausgedrückt werden als

$$\sigma_{PD} = \frac{d_{0/90}}{\pi_{44}}; \qquad \sigma_{12} = \frac{d_{45/135}}{\pi_D}$$

Aus der allgemeinen Widerstandsgleichung ergibt sich, daß für einen beliebigen Winkel $\psi$ gilt

$$s_{\Psi/\Psi+90} = \zeta$$

Im folgenden bezeichnet ein großes N oder ein großes P, jeweils hochgestellt, den Leitfähigkeitstyp des zugeordneten Bauteils. Gemäß der vorliegenden Erfindung wird eine Anordnung benutzt, die aus einem N-Widerstand besteht, der eine Serienschaltung zweier monolithischer Piezowiderstände vom N-Leitfähigkeitstyp umfaßt mit jeweils gleichen Abmessungen und gleichen Materialeigenschaften, die bei den Winkeln $\Psi^N$, $\Psi^N+90°$ liegen und einen P-Widerstand, der eine Serienschaltung aus zwei monolithischen Piezowiderständen vom P-Leitfähigkeitstyp umfaßt, mit den gleichen Abmessungen und den gleichen Materialeigenschaften, die bei den Winkeln $\Psi^P$, $\Psi^P+90°$ liegen. Die Summe der relativen Widerstandsänderungen des N-Widerstands und des P-Widerstands kann unter Zuhilfenahme eines Gewichtungsfaktors w geschrieben werden als

$$s^{N}_{\Psi N/\Psi N+90} + ws^{P}_{\Psi P/\Psi P+90} = (\pi^{N}_{S} + w\pi^{P}_{S})\sigma_{PH} + (\pi^{N}_{12} + w\pi^{P}_{12})\sigma_{33} + (\alpha^{N} + w\alpha^{P})\Delta T.$$

Wählt man nun $w=-k_{\alpha}$ mit $k_{\alpha} = \dfrac{\alpha^{N}}{\alpha^{P}}$, so ergibt sich in temperaturkompensierter Weise

$$\frac{s^{N}_{\Psi N/\Psi N+90} - k_{\alpha}s^{P}_{\Psi P/\Psi P+90}}{\pi^{N}_{S} - k_{\alpha}\pi^{P}_{S}} = \sigma_{PH} + \frac{\pi^{N}_{12} - k_{\alpha}\pi^{P}_{12}}{\pi^{N}_{S} - k_{\alpha}\pi^{P}_{S}}\sigma_{33}.$$

Im Wafer selbst und in den weit verbreiteten Kunststoff- und keramischen elektronischen Packages ist die Streß-Komponente $\sigma_{33}$ aus der Ebene heraus vernachlässigbar. Die letztgenannte Formel ergibt deshalb gerade die gewünschte Größe des sogenannten biaxialen hydrostatischen Drucks. Diese ist unabhängig von Änderungen der Temperatur. Bezüglich der absoluten Winkel der Widerstände können diese beliebig gewählt werden aufgrund der Winkel-Invarianz, welche sich oben ergab.

Die Auswerteschaltung der integrierten Halbleiteranordnung gemäß dem vorgeschlagenen Prinzip umfaßt bevorzugt ein Multiplizierglied. Das Multiplizierglied verknüpft einerseits eine Signaländerung, welche temperatur- und/oder druckabhängig sein kann und ebenfalls abgegriffen wird an den Bauteilen vom ersten Leitfähigkeitstyp und multipliziert diese Signaländerung mit dem Verhältnis der Temperaturkoeffizienten der Bauteile vom ersten und zweiten Leitfähigkeitstyp zueinander. Weiterhin ist bevorzugt ein Subtrahierglied vorgesehen zum Subtrahieren des Ausgangssignals des Multipliziergliedes von einer temperatur- und/oder druckabhängigen Signaländerung, welche wiederum an den Bauteilen vom zweiten Leitfähigkeitstyp abgegriffen wird.

Somit wird ein Signal abgegeben, welches praktisch temperäturunabhängig ist, aber dennoch proportional zur DruckKomponente in der Ebene, beispielsweise dem sogenannten biaxialen hydrostatischen Streß.

In einer weiteren, dazu alternativen Ausführungsform umfaßt die Auswerteschaltung ein Multiplizierglied zum Multiplizieren einer ersten Signaländerung, die an den Bauteilen vom ersten Leitfähigkeitstyp abgegriffen wird und temperaturund/oder druckabhängig sein kann, mit dem absoluten Verhältnis der Summen der druckabhängigen piezoresistiven Koeffizienten in der Hauptebene der integrierten Halbleiteranordnung der hierbei als Piezowiderstände ausgeführten Bauteile vom ersten und zweiten Leitfähigkeitstyp. Weiterhin ist dabei ein Addierglied vorgesehen, welches das Ausgangssignal des beschriebenen Multipliziergliedes von einer Signaländerung subtrahiert, welche an den Bauteilen vom zweiten Leitfähigkeitstyp abgegriffen wird und temperatur- und/oder druckabhängig sein kann.

Die druckabhängigen piezoresistiven Koeffizienten in der Hauptebene werden in der Literatur auch als piezoresistive Koeffizienten der Indizes 11 und 12 bezeichnet. Daraus wird sowohl für die Serienschaltung vom ersten Leitfähigkeitstyp als auch für die Serienschaltung vom zweiten Leitfähigkeitstyp jeweils die Summe gebildet.

In Analogie zu der obigen Herleitung der Formel zur Bestimmung für ein druckabhängiges, temperaturunabhängiges Signal ergibt sich im Falle des druckunabhängigen, temperaturabhängigen Signals der Zusammenhang:

$$\Delta T = \frac{s^{N}_{\Psi N/\Psi N+90} - k_{\pi}s^{P}_{\Psi P/\Psi P+90}}{\alpha^{N} + k_{\pi}\alpha^{P}}$$

wobei

$$k_{\pi} = \left|\frac{\pi^{N}_{S}}{\pi^{P}_{S}}\right|.$$

Bevorzugt haben die beiden Piezowiderstände vom ersten Leitfähigkeitstyp untereinander gleiche Abmessungen und gleiche Materialeigenschaften. Ebenso haben die beiden Piezowiderstände vom zweiten Leitfähigkeitstyp bevorzugt gleiche Abmessungen und gleiche Materialeigenschaften.

Die Piezowiderstände können als herkömmliche n- oder p-Widerstände ausgebildet sein. Alternativ können beide Widerstände auch in einer gemeinsamen Struktur integriert sein, welche als Van-der-Pauw-Struktur bezeichnet wird. Derartige Strukturen haben zwei Anschlußklemmenpaare, die orthogonal zueinander stehende Achsen definieren und demnach bei Beaufschlagung mit einem Signal in zwei normal zueinander stehenden Richtungen von einem Strom durchflossen werden. Diese beiden orthogonal zueinander in einem gemeinsamen Bauteil angeordneten Widerstände können dann gemäß dem vorgeschlagenen Prinzip seriell verschaltet werden.

Die Van-der-Pauw-Struktur ist bevorzugt scheibenförmig ausgeführt.

Alternativ können der erste und der zweite Piezowiderstand vom ersten und vom zweiten Leitfähigkeitstyp jeweils als n-bzw. p-Kanal eines Feldeffekttransistors ausgeführt und dort jeweils zwischen Source- und Drain-Elektrode angeordnet sein. Die Feldeffekttransistoren sind bevorzugt Metall-Isolator-Halbleiter-Transistoren, beispielsweise Metal Oxide Semiconductor(MOS)-Transistoren.

Gemäß dem vorliegenden Prinzip kann nicht nur ein temperaturproportionales, druckunabhängiges sowie ein temperaturunabhängiges druckproportionales Signal erzeugt werden bezüglich des hydrostatischen Druckes in der Hauptebene des Hauptleiters, sondern es ist auch ein zeitkontinuierliches Beobachten dieser beiden Parameter in einem Package nach der Einkapselung des sogenannten Die noch möglich, um Effekte zu beobachten wie Relaxation, viskoelastische Änderungen, Änderungen der Umgebung wie Temperatur und Feuchte et cetera. Ein solches Monitoring ermöglicht unter anderem den Vergleich einzelner Spritzgußgehäusetypen und Kunststoffe, Leadframes, und anderer Prozeßvarianten bei der Fertigung vom Aspekt der Streß-Eigenschaften betrachtet. Auch Prozesse im Nachgang der eigentlichen Fertigung wie Verlöten von Chips können ebenso genau qualifiziert und optimiert werden.

Natürlich ist auch eine On-Chip-Kompensation von Temperaturinduzierten Empfindlichkeitsänderungen bei Hall-Magnet-Sensoren und anderen Anwendungen ebenso möglich wie die On-Chip-Kompensation von druckinduzierten oder von durch mechanische Spannungen verursachten Veränderungen der elektrischen Eigenschaften von Hall-Magnet-Sensoren und anderen Bauteilen.

Natürlich ist das vorliegende Prinzip auch in anderen Halbleiteranwendungen mit Vorteil einsetzbar, beispielsweise allgemein bei der Chipfertigung von kostengünstigen, präzisen Analogschaltkreisen.

Die Aufgabe wird bezüglich des Verfahrens mit folgenden Schritten gelöst:

- Bereitstellen eines ersten Bauteils und eines zweiten Bauteils in einem rechten Winkel zueinander, die beide von einem ersten Leitfähigkeitstyp sind, in einer integrierten Schaltung und serielles Verschalten der Bauteile vom ersten Leitfähigkeitstyp miteinander,
- Bereitstellen eines ersten Bauteils und eines zweiten Bauteils in einem rechten Winkel zueinander, die beide von einem zweiten Leitfähigkeitstyp sind, in einer integrierten Schaltung und serielles Verschalten der Bauteile vom zweiten Leitfähigkeitstyp miteinander,
- Koppeln der Serienschaltung der Bauteile vom ersten Leitfähigkeitstyp mit der Serienschaltung der Bauteile vom zweiten Leitfähigkeitstyp derart, dass ein temperaturunabhängiges Drucksignal und/oder ein druckunabhängiges Temperatursignal abgegeben wird.

Die Funktionsweise mit ihren Vorteilen entspricht der der bereits oben ausführlich erläuterten Halbleiteranordnung und soll daher an dieser Stelle nicht wiederholt werden.

Bevorzugt erfolgt ein Verknüpfen einer Signaländerung abgegriffen über der Serienschaltung der Bauteile vom ersten Leitfähigkeitstyp mit einer Signaländerung abgegriffen über der Serienschaltung der Bauteile vom zweiten Leitfähigkeitstyp.

Vor dem Schritt des Verknüpfens erfolgt bevorzugt ein Gewichten einer an der Serienschaltung der Bauteile vom ersten Leitfähigkeitstyp abgegriffenen Signaländerung mit dem Verhältnis der Temperaturkoeffizienten der Bauteile vom ersten und zweiten Leitfähigkeitstyp beziehungsweise mit mit dem absoluten Verhältnis der Summe der piezoresistiven Koeffizienten der Bauteile vom ersten Leitfähigkeitstyp und der Summe der piezoresistiven Koeffizienten der Bauteile vom zweiten Leitfähigkeitstyp, jeweils bezüglich einer Ebene parallel zur Hauptebene der integrierten Schaltung,

Bezüglich des Verfahrens wird die Aufgabe im Hinblick auf die Erzeugung eines druckproportionalen, temperaturunabhängigen Signals bevorzugt durch folgende Verfahrensschritte gelöst:

- Bilden eines ersten Piezowiderstands und eines zweiten Piezowiderstands in einem rechten Winkel zueinander, die beide von einem ersten Leitfähigkeitstyp sind, in einer integrierten Schaltung und serielles Verschalten der Piezowiderstände miteinander,
- Bilden eines ersten Piezowiderstands und eines zweiten Piezowiderstands in einem rechten Winkel zueinander, die beide von einem zweiten Leitfähigkeitstyp sind, in einer integrierten Schaltung und serielles Verschalten der Piezowiderstände miteinander,
- Multiplizieren einer druck- und/oder temperaturinduzierten Widerstandsänderung der Piezowiderstände vom ersten Leitfähigkeitstyp mit dem Verhältnis der Temperaturkoeffizienten der Piezowiderstände vom ersten und zweiten Leitfähigkeitstyp und
- Subtrahieren des Ergebnisses der Multiplikation von einer druck- und/oder temperaturinduzierten Widerstandsänderung der Piezowiderstände vom zweiten Leitfähigkeitstyp.

Bezüglich des Verfahrens zur Erzeugung eines temperaturproportionalen, druckunabhängigen Signals wird die Aufgabe bevorzugt durch folgende Verfahrensschritte gelöst:

- Bilden eines ersten Piezowiderstands und eines zweiten Piezowiderstands in einem rechten Winkel zueinander, die beide von einem ersten Leitfähigkeitstyp sind, in einer integrierten Schaltung und serielles Verschalten der Piezowiderstände miteinander,

- Bilden eines ersten Piezowiderstands und eines zweiten Piezowiderstands in einem rechten Winkel zueinander, die beide von einem zweiten Leitfähigkeitstyp sind, in einer integrierten Schaltung und serielles Verschalten der Piezowiderstände miteinander,

- Multiplizieren einer druck- und/oder temperaturinduzierten Widerstandsänderung der Piezowiderstände vom ersten Leitfähigkeitstyp mit dem absoluten Verhältnis der Summe der piezoresistiven Koeffizienten der Piezowiderstände vom ersten Leitfähigkeitstyp und der Summe der piezoresistiven Koeffizienten der Piezowiderstände vom zweiten Leitfähigkeitstyp, jeweils bezüglich einer Ebene parallel zur Hauptebene der integrierten Schaltung und

- Addieren des Ergebnisses der Multiplikation von einer druck- und/oder temperaturinduzierten Widerstandsänderung der Piezowiderstände vom zweiten Leitfähigkeitstyp.

Bei den aufsummierten piezoresistiven Koeffizienten handelt es sich bevorzugt jeweils um diejenigen mit den Indizes 11 und 12. Dies ist bevorzugt auf eine (1 0 0)-Hauptebene bezogen.

Anstelle der Piezowiderstände können auch andere Bauteile verwendet werden, die eine druckabhängige elektrische Eigenschaft haben.

Die Funktionsweise und die sich daraus ergebenden Vorteile der Verfahrensprinzipien sowie deren mathematische Herleitung entsprechen dem oben bereits ausführlich Besprochenen und werden hier nicht noch einmal beschrieben.

Die Erfindung wird nachfolgend anhand von Ausführungsbeispielen an den Zeichnungen näher erläutert.

Es zeigen:

Figur 1    die allgemeine Anordnung von Bauteilen gemäß dem vorgeschlagenen Prinzip,

Figur 2    ein erstes Ausführungsbeispiel für die Implementierung eines integrierten Piezowiderstands zur Anwendung in der Halbleiteranordnung von Figur 1,

Figur 3    eine Ausführung von zwei Widerständen vom gleichen Leitfähigkeitstyp in einer gemeinsamen, scheibenförmigen Van-der-Pauw-Struktur,

Figur 4    eine Konverterschaltung als Hilfsschaltung zur Gewinnung eines temperaturunabhängigen Signals,

Figur 5    eine Schaltung zur Erzeugung eines druckabhängigen Signals,

Figur 6    eine beispielhafte Schaltung zur Gewinnung der Scherspannung und

Figur 7    ein Ausführungsbeispiel einer Schaltung zur Erzeugung eines temperaturproportionalen, druckunabhängigen Signals.

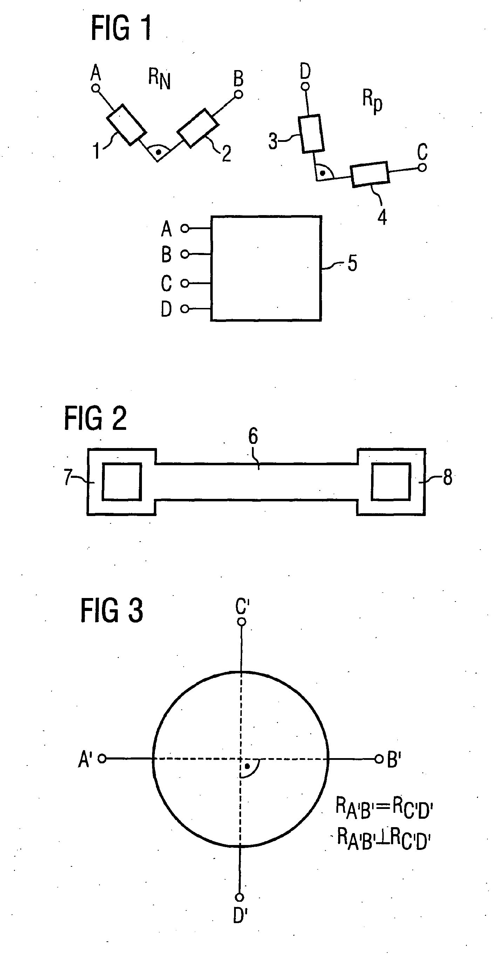

Figur 1 zeigt eine Halbleiteranordnung, welche zwei Serienschaltungen $R_N$, $R_P$ aufweist. Die erste Serienschaltung $R_N$ umfasst zwei Widerstände 1, 2, welche als Piezowiderstände ausgeführt, von einem n-Leitfähigkeitstyp und in einem Winkel von 90 Grad zueinander angeordnet sind. Die Serienschaltung hat zwei Anschlußklemmen, welche mit A und B bezeichnet sind. Die Serienschaltung $R_P$ umfaßt ebenfalls zwei Widerstände, 3, 4, welche jedoch von einem entgegengesetzten p-Leitfähigkeitstyp, ebenfalls als Piezowiderstände ausgeführt und in einem Winkel von 90 Grad zueinander angeordnet sind. Die Serienschaltung $R_P$ hat Anschlußklemmen C, D. Die Widerstände 1, 2 sind jeweils monolithisch integriert und haben gleiche Abmessungen und gleiche Materialeigenschaften. Die Widerstände 3, 4 sind monolithisch integriert und haben gleiche Abmessungen und gleiche Materialeigenschaften. Eine Auswerteschaltung 5 ist an die Anschlußklemmen A, B, C, D der beiden Serienschaltungen angeschlossen. Die Auswerteschaltung 5 umfaßt sowohl Mittel zur Signalerzeugung zum Beaufschlagen der Serienschaltungen mit jeweiligen elektrischen Signalen als auch Mittel zur Signalerfassung sowie in dem eigentlichen Auswerteblock Mittel zur Multiplikation, Addition und Subtraktion von Signalen. Am Ausgang der Auswerteschaltung 5 kann je nach Ausführung der Auswerteschaltung, die nachfolgend beispielhaft erläutert werden, entweder ein temperaturunabhängiges, druckproportionales Signal oder ein druckunabhängiges, temperaturproportionales Signal oder beides abgegriffen werden.

Figur 2 zeigt ein Ausführungsbeispiel eines konventionellen, monolithisch integrierten Widerstandes, der in der aktiven Oberfläche eines Siliziumwafers angeordnet ist in einer Ausführung als individuelles, passives Bauteil. Der monolithische Widerstand 6 ist im wesentlichen rechteckig aufgebaut oder auch als Zusammensetzung rechteckiger Grundflächen, bei Betrachtung der Oberfläche des Wafers. Der Widerstand 6 hat zwei Anschlußklemmen 7, 8, welche die Stromflußrichtung durch den Widerstand 6 festlegen.

Die Widerstände 1 bis 4 von Figur 1 können jeweils eine wie in Figur 2 gezeigte Struktur haben.

Alternativ kann auch je ein Widerstandspaar 1, 2; 3, 4 in einer scheibenförmigen Van-der-Pauw-Struktur mit orthogonalen Symmetrieachsen ausgeführt sein. Wenn man zwei derartige zirkulare Van-der-Pauw-Strukturen in Serie schaltet, von denen eine an den Anschlüssen A und B und die andere an den Anschlüssen C und D verbunden wird, bietet diese Kombination die gleichen Streß- und Temperaturabhängigkeiten wie eine Kombination konventioneller Widerstände. Man erkennt in Figur 3 die rechtwinklig zueinander angeordneten Achsen, welche jeweils durch Anschlußklemmenpaare definiert sind, die orthogonal zueinander stehen. Die dadurch gebildeten, orthogonalen Widerstände haben selbstverständlich den gleichen Widerstandswert.

Alternativ kann auch jede andere Struktur verwendet werden, die durch eine konforme Abbildung aus der scheibenförmigen Geometrie gewonnen werden kann.

Die orthogonale Van-der-Pauw-Struktur ermöglicht es, lediglich eine Struktur zu verwenden anstelle von zwei. In diesem Fall wird zunächst der Widerstand entlang einer ersten Achse gemessen und der ermittelte Wert gespeichert. In einem zweiten Schritt wird der Widerstandswert entlang der orthogonalen Achse gemessen und zu den bereits gespeicherten Daten addiert. Die dadurch gebildete Widerstandssumme wird an die Auswerteschaltkreise weitergeleitet, wie nachfolgend erläutert.

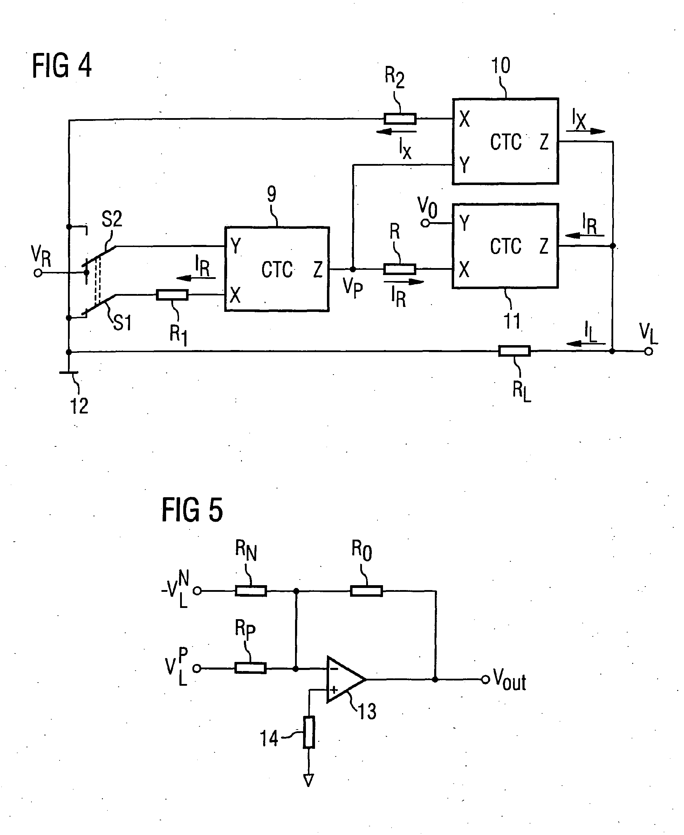

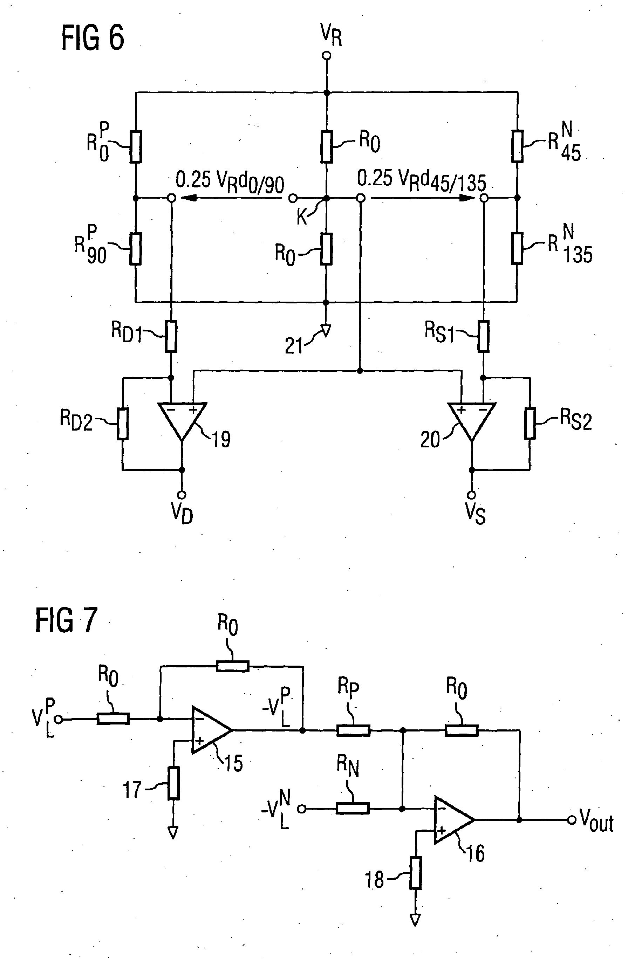

Figuren 4 und 5 zeigen eine beispielhafte Implementierung eines elektronischen Schaltkreises zur Ermittlung des hydrostatischen Drucks in der Hauptebene der Halbleiteranordnung gemäß vorliegendem Prinzip.

Die Konverterschaltung gemäß Figur 4 umfaßt insgesamt drei Strom-zu-Strom-Konverter-Schaltkreise 9, 10, 11. Jeder der Konverter 9 bis 11 hat drei Anschlußklemmen, die jeweils mit x, y, z bezeichnet sind. Ein Widerstand R ist zwischen dem Anschluß z des Konverters 9 und dem Anschluß x des Konverters 11 geschaltet und umfaßt zwei 90 Grad zueinander angeordnete Abschnitte wie in Figur 1 gezeigt. Die beiden Teilwiderstände haben jeweils den Widerstandswert $\frac{\bar{R}}{2}$, wobei es sich um einen mechanisch unbeanspruchten Widerstand bei Referenztemperatur handelt. Zwischen den x-Anschluß des Konverters 9 und Bezugspotential 12 ist ein Widerstand R1 und ein Schalter S1 geschaltet. Der y-Anschluß des Konverters 9 ist über einen Schalter S2 schaltbar mit Bezugspotential 12 verbunden. Die Schalter S1, S2, die gleichzeitig betätigt werden, koppeln die Anschlüsse x, y des Konverters 9 über einen Widerstand R1 bzw. unmittelbar entweder mit Bezugspotential 12 oder mit einem Referenzspannungsanschluß $V_R$. Der x-Anschluß des Konverters 10 ist über einen Widerstand R2 am Bezugspotential 12 gelegt. Der y-Anschluß des Konverters 10 ist mit dem z-Anschluß des Konverters 9 in einem Spannungsknoten $V_P$ verbunden. Der y-Anschluß des Konverters 11 ist an ein Potential $V_0$ gelegt. Die z-Anschlüsse der Konverter 10, 11 sind miteinander und einem Spannungsknoten $V_L$ verbunden. Der Spannungsknoten $V_L$ ist über einen Widerstand $R_L$ an Bezugspotential 12 gelegt.

Die Funktion der Schaltung von Figur 4 wird nachfolgend anhand der sie beschreibenden Formeln erläutert. Die Widerstände R1, R2, $R_L$ haben identische Winkelpositionen mit einer relativen Widerstandsänderung $\delta$. In den nachfolgenden Gleichungen entsprechen die Werte der verwendeten Bauteile und der vorhandenen Signale den in Figur 4 gezeigten Bezugszeichen.

$$I_R = \frac{V_R}{R_1}; \qquad V_P = V_0 + I_R R ; \qquad I_X = \frac{V_P}{R_2} = \frac{V_0}{R_2} + I_R \frac{R}{R_2} ; \qquad I_L = I_R \frac{V_P}{R_2} - I_R + \frac{V_0}{R_2}$$

Aus Kombination obiger Gleichungen ergibt sich:

$$\frac{V_L}{I_R \bar{R_L}} = A\zeta - \delta + \left( A - 1 + \frac{V_0}{I_R \bar{R_2}} \right); \qquad A = \frac{\bar{R}}{\bar{R_2}}$$

Setzt man im Waferzustand die Spannung $V_L = 0$, das heißt man wählt:

$$V_0 = -V_R \frac{\bar{R} - \bar{R_2}}{\bar{R_1}},$$

so führt das zur Ausgangsspannung

$$\frac{V_L}{I_R \overline{R_L}} = A\zeta - \delta \cong A\zeta$$

Wenn der "Verstärkungsfaktor" A ungefähr 10 beträgt, ist der Effekt des zweiten Terms vernachlässigbar. Es ist anzumerken, daß die Offset-Eliminierung kein Trimming benötigt, sondern durch lediglich Geometrieverhältnisse festgelegt werden kann. Der Strom $I_R$ und die Spannung $V_L$ ändern ihr Vorzeichen bei Betätigung des Doppelschalters S1, S2, der gleichzeitig geschaltet wird.

Figur 5 zeigt einen Addierschaltkreis, der die Spannungen eines jeweiligen n-Leitfähigkeitstyp-Schaltungsblock und eines p-Leitfähigkeitstyps-Schaltungsblock wie jeweils in Figur 4 gezeigt, miteinander summiert bei jeweils entgegengesetzten Referenzstromrichtungen.

Der Addierschaltkreis gemäß Figur 5 zeigt Widerstände, die alle den gleichen Leitfähigkeitstyp, die gleichen Materialeigenschaften und die gleichen Widerstandspositionen zueinander aufweisen.

Figur 5 zeigt einen Operationsverstärker 13, mit einem Plus-Eingang, der über einen Widerstand 14 auf Masse gelegt ist und mit einem Minus-Eingang, der über einen Rückkopplungswiderstand $R_0$ mit dem Ausgangsanschluß $V_{out}$ des Operationsverstärkers 13 verbunden ist. Der Minus-Eingang des Operationsverstärkers 13 ist über einen Widerstand $R_N$ an eine erste Eingangsklemme $-V_L{}^N$ und über einen Widerstand $R_P$ an eine weitere Klemme $V_L{}^P$ gelegt.

Die Ausgangsspannung unter Beachtung der obigen Gleichungen ergibt sich zu

$$V_{OUT} = V_R A^N \frac{\overline{R_L^N}}{R_1^N} \frac{\overline{R_0}}{R_N} \left( \frac{\zeta^N}{1+\delta^N} - \frac{\overline{k_\alpha \zeta^P}}{1+\delta^P} \right) \qquad \frac{\overline{R_L^P}}{R_1^P} \frac{\overline{R_1^N}}{R_L^N} \frac{\overline{R_N}}{R_P} \frac{A^P}{A^N} = \overline{k_\alpha} \ .$$

Wählt man eine Normalisierungskonstante $\theta_0$ und setzt

$$A^N \frac{\overline{R_L^N}}{R_1^N} \frac{\overline{R_0}}{R_N} = \frac{1}{\sigma_0 \left( \pi_S^N - k_\alpha \pi_S^P \right)},$$

so erhält man

$$\sigma_{PH} \cong \frac{V_{OUT}}{V_R} \sigma_0.$$

Die Eliminierung von Offsets und die Anpassung der Konstanten kann auch hier mit sehr hoher Genauigkeit durch Geometrieverhältnisse ohne jegliches Trimming bewirkt werden. Es kann eine sehr geringe Druck- und Temperaturabhängigkeit übrig bleiben. Diese kann jedoch höchstens zu einer Abhängigkeit zweiter Ordnung im Ergebnis führen. Die Ausgangsspannung ergibt einen Wert proportional zum hydrostatischen Druck in der Hauptebene. Diese Spannung kann dazu benutzt werden, den Zustand des biaxialen hydrostatischen Drucks in elektronischen Packages zu überwachen.

Der vollständige Zustand der mechanischen Spannungen in der Hauptebene des Halbleiters kann falls gewünscht durch Hinzufügen der Werte des bekannten Spannungsunterschieds in der Ebene und der Scherspannungskomponenten zum Ergebnis der Schaltung gemäß Figur 5 hinzugefügt werden. Ein Realisierungsbeispiel mit einer Brücke von Piezowiderständen, die zwei Operationsverstärker treiben, ist in Figur 6 gezeigt.

In Figur 6 bilden zwei Operationsverstärker 19, 20 Signalausgänge $V_D$, $V_S$ und sind über je einen Widerstand $R_{D2}$, $R_{S2}$ an den invertierenden Eingang rückgekoppelt. Die nicht invertierenden Eingänge der Operationsverstärker 19, 20 sind an einen Knoten K der Brückenschaltung gelegt, der über je einen Widerstand $R_0$ mit dem Spannungsknoten $V_R$ und einem Bezugspotentialanschluß 21 verbunden ist. Parallel zur Serienschaltung der beiden Widerstände $R_0$ sind je eine Serienschaltung von p-und n-Widerständen geschaltet. Die p-Widerstände $R_0{}^P$ und $R_{90}{}^P$ sind in einem Winkel von 90 Grad zueinander angeordnet, ebenso die Widerstände $R_{45}{}^N$ und $R_{135}{}^N$. Abgriffspunkte zwischen den p- und den n-dotierten Widerständen sind über je einen Widerstand $R_{D1}$, $R_{S1}$ mit den invertierenden Eingängen der zugeordneten Operationsverstärker 19, 20 verbunden. Der mittlere Zweig der Widerstände $R_0$ kann entweder von einem p- oder von einem n-Leitfähigkeitstyp sein, jedenfalls müssen beide Widerstände $R_0$ in gleicher Richtung integriert sein. Man kann zeigen, daß der Spannungsoffset der äußeren Spannungsteiler in Figur 6 mit Bezug zum Zentralknoten K des mittleren Zweiges ausgedrückt werden kann als

$$\frac{\Delta V}{V_R} = \frac{d_{\Psi/\Psi+90}}{4(1 + \zeta)} \cong 0.25 d_{\Psi/\Psi+90}.$$

Wählt man

$$\frac{R_{D1}}{R_{D2}} = 0.25\pi_{44}^P\sigma_0 \; ; \qquad \frac{R_{S1}}{R_{S2}} = 0.25\pi_D^N\sigma_0,$$

so ergibt sich

$$\sigma_{PD} \cong \frac{V_D}{V_R}\sigma_0; \qquad \sigma_{12} \cong \frac{V_S}{V_R}\sigma_0.$$

Die nachfolgend dargestellte Tabelle 1 zeigt beispielhafte Werte der piezoresistiven, Piezo-Hall- und TemperaturKoeffizienten für einen typischen Fertigungsprozeß eines (100) Siliziumwafers, wie er in der industriellen Fertigung weitgehend Verwendung findet.

Tabelle 1

| [Tpa$^{-1}$] | N-Typ Silizium | P-Typ Silizium |
|---|---|---|
| $\pi_{11}$ | -1022 | 66 |
| $\pi_{13}$ | 534 | -11 |
| $\pi_{44}$ | -136 | 1381 |
| $\pi_S$ | -488 | 55 |
| $\pi_D$ | -1556 | 77 |
| $p_{11}$ | -880 | ./. |
| $p_{13}$ | 450 | ./. |
| $p_{44}$ | 100 | ./. |
| $\alpha$ | $6{,}5 \times 10^{-3}$ (N-Wanne) | $1{,}7 \times 10^{-3}$ (P$^+$) |

Wie man erkennt, haben die Koeffizienten $\pi_S^N$ und $\pi_S^P$ entgegengesetzte Vorzeichen. Wählt man $w = k_\pi$ mit

$$k_\pi = \left| \frac{\pi_S^N}{\pi_S^P} \right| ,$$

so ergibt sich die Temperaturänderung in druckunabhängiger Art und Weise zu

$$\Delta T = \frac{S_{\Psi N/\Psi N+90}^N + k_\pi S_{\Psi P/\Psi P+90}^P}{\alpha^N + k_\pi \alpha^P}.$$

Der Term, der die Streßkomponente aus der Ebene heraus umfaßt, die mit $\sigma_{33}$ bezeichnet ist, wurde weggelassen, da diese im biaxialen oder ebenen mechanischen Spannungszustand, der hier diskutiert wird, den Wert Null hat.

Figur 7 zeigt eine Schaltung zur Erzeugung eines druckunabhängigen Temperatursignals, welches ebenfalls die Strom-Konverter von Figur 4, genauer dessen Ausgangssignale, mit benutzt. Die Ausgangsanschlüsse der Schaltung von Figur 4 werden nun nicht mehr zur Bestimmung der temperaturunabhängigen biaxialen hydrostatischen mechanischen Spannung benutzt sondern an der zusätzlichen Operationsverstärkerschaltung von Figur 7 angeschlossen.

Die Schaltung von Figur 7 umfaßt zwei Operationsverstärker 15, 16, die über je einen Widerstand 17, 18 gegen Bezugspotential geschaltet sind. Eingangsanschlußklemme $V_L{}^P$ ist über einen Widerstand $R_0$ an den invertierenden Eingang des Operationsverstärkers 15 geschaltet. Ein weiterer Widerstand $R_0$ ist zwischen den Ausgang und den invertierenden Eingang des Operationsverstärkers 15 geschaltet, wobei der Ausgang die Anschlußklemme -$V_L{}^P$ bildet und über einen Widerstand $R_P$ mit dem invertierenden Eingang des Operationsverstärkers 16 verbunden ist. Eingangsspannungsknoten -$V_L{}^N$ ist über einen Widerstand $R_N$ mit dem invertierenden Eingang des Operationsverstärkers 16 verbunden, der zusätzlich über einen Widerstand $R_0$ mit dem Ausgang $V_{out}$ des Operationsverstärkers 16 verbunden ist. Insofern entspricht die Beschaltung des Operationsverstärkers 16 von Figur 7 derjenigen von Operationsverstärker 13 in Figur 5 und kann entsprechend mitbenutzt werden.

Mit analogen Überlegungen wie oben werden die Widerstandswerte so gewählt, daß sich mit einer Referenztemperaturänderung $\Delta T_0$ folgende Gleichung ergibt:

$$\Delta T = \frac{V_{OUT}}{V_R} \Delta T_0$$

Mit den Werten von Tabelle 1 ist der wirksame Temperaturkoeffizient verhältnismäßig groß: Es ergibt sich eine Zahl von mehr als $2 \times 10^{-2}$ pro Grad Celsius, was eine hochsensible Temperaturerfassung ermöglicht.

Wenn man die gesamten Schaltkreise von Figuren 4 bis 7 in einem integrierten Schaltkreis, beispielsweise der Auswerteschaltung 5 von Figur 1 integriert, kann man den vollständigen Zustand der mechanischen Spannung in der Ebene in temperaturkompensierter Weise messen und zusätzlich die Temperatur in einer druckunabhängigen Weise.

Wenn man bevorzugt diese Schaltkreise an verschiedenen geometrischen Positionen des Chips integriert, kann auch die Druck- und Temperaturverteilung und ihre zeitliche Schwankung über die komplette Oberfläche des Chips beobachtet werden.

Bei einer anderen Realisierung brauchen nur die als Sensoren arbeitenden Widerstände von Figur 1 über die Chipfläche verteilt werden und diese Anschlüsse mit den auswertenden elektronischen Schaltungen über Multiplexer angeschlossen werden.

Die rein temperaturabhängigen, aber nicht druckabhängigen Signale der vorliegenden Schaltungen können beispielsweise dazu benutzt werden, Temperaturschwankungen anderer Schaltkreiselemente wie Hall-Platten zu kompensieren.

Das Korrektursignal der vorliegenden Erfindung ist dazu besonders gut geeignet, da es frei von einer Druckabhängigkeit ist und es deshalb ermöglicht, eine wahre Temperaturkompensation zu erzielen.

Die Empfindlichkeit eines sogenannten horizontalen Hall-Elementes beispielsweise schwankt nicht nur mit der Temperatur, sondern auch in Abhängigkeit von mechanischen Spannungen bzw. mechanischem Druck, der auf den Chip einwirkt, wie der folgende Zusammenhang zeigt:

$$\sigma_{PH} = \frac{1}{2p_{12}} \frac{\Delta S_H}{S_H}$$

Da mit der vorliegenden Erfindung der hydrostatische Druck in der Ebene in unabhängiger Weise gewonnen wird, ermöglicht es das vorliegende Prinzip, die letztgenannte Formel zu invertieren:

$$\frac{\Delta S_H}{S_H} \cong 2p_{12}\sigma_{PH}$$

Daher erlaubt es das geschilderte Prinzip, eine zeitkontinuierliche On-Chip-Kompensation der Hall-Empfindlichkeitsänderungen durchzuführen. Dies kann beispielsweise dadurch erfolgen, indem der Speisestrom der Hall-Zelle geregelt wird oder beispielsweise dadurch, daß in nachgeschalteten Verstärkern Faktoren der Signalverstärkung proportional zum hydrostatischen Druck im Chip angepaßt werden.

**Patentansprüche**

1.  Integrierte Halbleiteranordnung, umfassend

    - ein erstes Bauteil von einem ersten Leitfähigkeitstyp (1) mit druckabhängiger elektrischer Eigenschaft,
    - ein zweites Bauteil vom ersten Leitfähigkeitstyp (2) mit druckabhängiger elektrischer Eigenschaft, das im rechten Winkel zum ersten Bauteil vom ersten Leitfähigkeitstyp angeordnet und mit diesem in einer Serienschaltung verschaltet ist,
    - ein erstes Bauteil von einem zweiten Leitfähigkeitstyp (3) mit druckabhängiger elektrischer Eigenschaft,
    - ein zweites Bauteil vom zweiten Leitfähigkeitstyp (4) mit druckabhängiger elektrischer Eigenschaft, das im rechten Winkel zum ersten Bauteil vom zweiten Leitfähigkeitstyp angeordnet und mit diesem in einer Serienschaltung verschaltet ist, und
    - eine Auswerteschaltung (5), die mit den Serienschaltungen der Bauteile vom ersten und vom zweiten Leitfähigkeitstyp (1, 2; 3, 4) gekoppelt und so ausgelegt ist, daß an einem Ausgang der Auswerteschaltung ein temperaturunabhängiges Drucksignal und/oder ein druckunabhängiges Temperatursignal abgegeben wird.

2.  Halbleiteranordnung nach Anspruch 1,
    **dadurch gekennzeichnet, daß**
    die Auswerteschaltung (5) Mittel zum Verknüpfen einer an der Serienschaltung der Bauteile vom ersten Leitfähigkeitstyp (1, 2) abgegriffenen Signaländerung mit einer an der Serienschaltung der Bauteile vom zweiten Leitfähigkeitstyp (3, 4) abgegriffenen Signaländerung umfasst.

3.  Halbleiteranordnung nach Anspruch 2,
    **dadurch gekennzeichnet, daß**
    die Auswerteschaltung (5) Mittel zum Gewichten einer an der Serienschaltung der Bauteile vom ersten Leitfähigkeitstyp (1, 2) abgegriffenen Signaländerung mit dem Verhältnis der Temperaturkoeffizienten der Bauteile vom ersten und zweiten Leitfähigkeitstyp (1, 2; 3, 4) beziehungsweise mit dem absoluten Verhältnis der Summen der druckabhängigen piezoresitiven Koeffizienten in der Hauptebene der integrierten Halbleiteranordnung der Bauteile vom ersten und zweiten Leitfähigkeitstyp (1, 2; 3, 4) umfasst.

4.  Halbleiteranordnung einem der Ansprüche 1 bis 3,
    **dadurch gekennzeichnet, daß**
    die Auswerteschaltung (5) ein Multiplizierglied umfaßt zum Verknüpfen einer temperatur- und/oder druckabhängigen Signaländerung abgegriffen an den Bauteilen vom ersten Leitfähigkeitstyp (1, 2) mit dem Verhältnis der Temperaturkoeffizienten der Bauteile vom ersten und zweiten Leitfähigkeitstyp (1, 2; 3, 4) und daß
    ein Subtrahierglied vorgesehen ist zum Subtrahieren des Ausgangssignals des Multiplizierglieds von einer temperaturund/oder druckabhängigen Signaländerung abgegriffen an den Bauteilen vom zweiten Leitfähigkeitstyp (3, 4).

5.  Halbleiteranordnung einem der Ansprüche 1 bis 3,
    **dadurch gekennzeichnet, daß**
    die Auswerteschaltung (5) ein Multiplizierglied umfaßt zum Verknüpfen einer temperatur- und/oder druckabhängigen Signaländerung abgegriffen an den Bauteilen vom ersten Leitfähigkeitstyp (1, 2) mit dem absoluten Verhältnis der Summen der druckabhängigen piezoresitiven Koeffizienten in der Hauptebene der integrierten Halbleiteranordnung der als Piezowiderstände ausgeführten Bauteile vom ersten und zweiten Leitfähigkeitstyp (1, 2; 3, 4), und daß
    ein Addierglied vorgesehen ist zum Addieren des Ausgangssignals des Multiplizierglieds von einer temperatur- und/oder druckabhängigen Signaländerung abgegriffen an den Bauteilen vom zweiten Leitfähigkeitstyp (3, 4).

6.  Halbleiteranordnung nach einem der Ansprüche 1 bis 5,
    **dadurch gekennzeichnet, daß**
    die Bauteile vom ersten und vom zweiten Leitfähigkeitstyp (1, 2, 3, 4) als Piezowiderstände ausgeführt sind.

7.  Halbleiteranordnung nach Anspruch 6,
    **dadurch gekennzeichnet, daß**
    die Piezowiderstände jeweils monolithisch integrierte Bauteile sind.

8.  Halbleiteranordnung nach Anspruch 6 oder 7,

**dadurch gekennzeichnet, daß**

daß die beiden Piezowiderstände vom ersten Leitfähigkeitstyp (1, 2) gleiche Abmessungen und gleiche Materialeigenschaften haben und daß die beiden Piezowiderstände vom zweiten Leitfähigkeitstyp (3, 4) gleiche Abmessungen und gleiche Materialeigenschaften haben.

9.  Halbleiteranordnung nach einem der Ansprüche 6 bis 8,
    **dadurch gekennzeichnet, daß**
    der erste und der zweite Piezowiderstand vom ersten Leitfähigkeitstyp (1, 2) als gemeinsames Bauteil mit Van-der-Pauw-Struktur ausgeführt sind, welches zwei Anschlussklemmenpaare aufweist, die orthogonal zueinander stehende Achsen definieren, und
    daß der erste und der zweite Piezowiderstand vom zweiten Leitfähigkeitstyp (3, 4) als gemeinsames Bauteil mit Van-der-Pauw-Struktur ausgeführt sind, welches zwei Anschlussklemmenpaare aufweist, die orthogonal zueinander stehende Achsen definieren.

10. Halbleiteranordnung nach Anspruch 9,
    **dadurch gekennzeichnet, daß**
    das gemeinsame Bauteil mit Van-der-Pauw-Struktur scheibenförmig ausgebildet ist.

11. Halbleiteranordnung nach einem der Ansprüche 6 bis 8,
    **dadurch gekennzeichnet, daß**
    der erste und der zweite Piezowiderstand vom ersten und vom zweiten Leitfähigkeitstyp (1, 2; 3, 4) jeweils als n- beziehungsweise p-Kanal eines MOS-Transistors ausgeführt und zwischen Source- und Drain-Elektrode angeordnet sind.

12. Verfahren zur Bereitstellung eines druckabhängigen Signals oder eines temperaturabhängigen Signals mit folgenden Verfahrensschritten:

    - Bereitstellen eines ersten Bauteils (1) und eines zweiten Bauteils (2) in einem rechten Winkel zueinander, die beide von einem ersten Leitfähigkeitstyp sind, in einer integrierten Schaltung und serielles Verschalten der Bauteile vom ersten Leitfähigkeitstyp (1, 2) miteinander,
    - Bereitstellen eines ersten Bauteils (3) und eines zweiten Bauteils (4) in einem rechten Winkel zueinander, die beide von einem zweiten Leitfähigkeitstyp sind, in einer integrierten Schaltung und serielles Verschalten der Bauteile vom zweiten Leitfähigkeitstyp (3, 4) miteinander,
    - Koppeln der Serienschaltung der Bauteile vom ersten Leitfähigkeitstyp (1, 2) mit der Serienschaltung der Bauteile vom zweiten Leitfähigkeitstyp (3, 4) derart, dass ein temperaturunabhängiges Drucksignal und/oder ein druckunabhängiges Temperatursignal abgegeben wird.

13. Verfahren nach Anspruch 12,
    **gekennzeichnet durch**
    Verknüpfen einer Signaländerung abgegriffen über der Serienschaltung der Bauteile vom ersten Leitfähigkeitstyp (1, 2) mit einer Signaländerung abgegriffen über der Serienschaltung der Bauteile vom zweiten Leitfähigkeitstyp (3, 4).

14. Verfahren nach Anspruch 13,
    **gekennzeichnet durch**
    Gewichten einer an der Serienschaltung der Bauteile vom ersten Leitfähigkeitstyp (1, 2) abgegriffenen Signaländerung mit dem Verhältnis der Temperaturkoeffizienten der Bauteile vom ersten und zweiten Leitfähigkeitstyp (1, 2; 3, 4) beziehungsweise mit mit dem absoluten Verhältnis der Summe der piezoresistiven Koeffizienten der Bauteile vom ersten Leitfähigkeitstyp (1, 2) und der Summe der piezoresistiven Koeffizienten der Bauteile vom zweiten Leitfähigkeitstyp (3, 4), jeweils bezüglich einer Ebene parallel zur Hauptebene der integrierten Schaltung, vor dem Schritt des Verknüpfens der Signaländerung abgegriffen über der Serienschaltung der Bauteile vom ersten Leitfähigkeitstyp (1, 2) mit der Signaländerung abgegriffen über der Serienschaltung der Bauteile vom zweiten Leitfähigkeitstyp (3, 4).

15. Verfahren nach einem der Ansprüche 12 bis 14,
    **gekennzeichnet durch**

    - Multiplizieren einer druck- und/oder temperaturinduzierten Widerstandsänderung der Bauteile vom ersten Leitfähigkeitstyp (1, 2) mit dem Verhältnis der Temperaturkoeffizienten der Bauteile vom ersten und zweiten Leitfähigkeitstyp (1, 2; 3, 4) und

- Subtrahieren des Ergebnisses der Multiplikation von einer druck- und/oder temperaturinduzierten Widerstandsänderung der Bauteile vom zweiten Leitfähigkeitstyp (3, 4), somit Bereitstellen eines druckabhängigen, Temperatur-unabhängigen Signals.

16. Verfahren nach einem der Ansprüche 12 bis 14,
**gekennzeichnet durch**

- Multiplizieren einer druck- und/oder temperaturinduzierten Widerstandsänderung der Bauteile vom ersten Leitfähigkeitstyp (1, 2) mit dem absoluten Verhältnis der Summe der piezoresistiven Koeffizienten der Bauteile vom ersten Leitfähigkeitstyp (1, 2) und der Summe der piezoresistiven Koeffizienten der Bauteile vom zweiten Leitfähigkeitstyp (3, 4), jeweils bezüglich einer Ebene parallel zur Hauptebene der integrierten Schaltung und
- Addieren des Ergebnisses der Multiplikation von einer druck- und/oder temperaturinduzierten Widerstandsänderung der Bauteile vom zweiten Leitfähigkeitstyp (3, 4), somit Bereitstellen eines temperaturabhängigen, Druck-unabhängigen Signals.

17. Verfahren nach einem der Ansprüche 12 bis 16,
**dadurch gekennzeichnet, daß**
die Bauteile (1, 2, 3, 4) Widerstände sind.

18. Verfahren nach einem der Ansprüche 12 bis 17,
**dadurch gekennzeichnet, daß**
die Bauteile (1, 2, 3, 4) Piezowiderstände sind.

19. Verfahren nach Anspruch 18,
**dadurch gekennzeichnet, daß**
die Piezowiderstände (1, 2, 3, 4) monolithisch integriert sind.

20. Verfahren nach einem der Ansprüche 12 bis 19,
**dadurch gekennzeichnet, daß**
die Bauteile (1, 2, 3, 4) in Form von Kanälen von Feldeffekttransistoren gebildet werden zwischen je einer Source- und einer Drain-Elektrode.

21. Verfahren nach einem der Ansprüche 12 bis 19,
**dadurch gekennzeichnet, daß**
die Piezowiderstände vom ersten Leitfähigkeitstyp (1, 2) in einer gemeinsamen Van-der-Pauw-Struktur integriert werden mit zwei Anschlussklemmenpaaren, die orthogonal zueinander stehende Achsen definieren, und daß die Piezowiderstände vom zweiten Leitfähigkeitstyp (3, 4) in einer gemeinsamen Van-der-Pauw-Struktur integriert werden mit zwei Anschlussklemmenpaaren, die orthogonal zueinander stehende Achsen definieren.

22. Verfahren nach Anspruch 21,
**dadurch gekennzeichnet, daß**
die Van-der-Pauw-Strukturen scheibenförmig integriert sind.

23. Verfahren nach Anspruch 21,
**dadurch gekennzeichnet, daß**
die Van-der-Pauw-Strukturen in einer Form integriert werden, die durch konforme Abbildung aus einer scheibenförmigen Van-der-Pauw-Struktur abgeleitet werden.

24. Verfahren zum Überwachen von Eigenschaften eines Chips, bei dem ein Verfahren nach einem der Ansprüche 12 bis 23 an mehreren Stellen des Halbleiter-Chips eingesetzt wird, um die Druck- beziehungsweise Temperatureigenschaften des Halbleiter-Chips zu überwachen.

25. Anwendung eines Verfahrens nach einem der Ansprüche 12 bis 23 in einem Hall-Magnetsensor zur Temperatur-beziehungsweise Druckkompensation.

FIG 1

$R_N$

A

B

1

2

D

$R_p$

3

C

4

A
B
C
D

5

FIG 2

6

7

8

FIG 3

C'

A'

B'

D'

$R_{A'B'} = R_{C'D'}$

$R_{A'B'} \perp R_{C'D'}$

EP 1 496 344 A2

**FIG 4**

**FIG 5**

FIG 6

FIG 7